# EUROPÄISCHE PATENTSCHRIFT

(11) **EP 2 697 561 B1**
(45) Veröffentlichungstag und Bekanntmachung des Hinweises auf die Patenterteilung: **16.05.2018**
(21) Anmeldenummer: 12708265.9
(22) Anmeldetag: 15.02.2012
(51) Int. Cl.: F21K 9/65, H01L 33/58

(54) **VORRICHTUNG UND VERFAHREN ZUM BEEINFLUSSEN EINER ABSTRAHLCHARAKTERISTIK EINER LICHTEMITTIERENDEN DIODE**
DEVICE AND METHOD FOR MANIPULATING AN EMISSION CHARACTERISTIC OF A LIGHT-EMITTING DIODE
DISPOSITIF ET PROCÉDÉ PERMETTANT D'INFLUER SUR UNE CARACTÉRISTIQUE DE RAYONNEMENT D'UNE DIODE ÉLECTROLUMINESCENTE

(30) Priorität: 13.04.2011 DE 102011007328
(43) Veröffentlichungstag der Anmeldung: 19.02.2014
(73) Patentinhaber: Robert Bosch GmbH, 70442 Stuttgart (DE)
(72) Erfinder: KRAUSS, Andreas, 72072 Tuebingen (DE)
(86) Internationale Anmeldenummer: PCT/EP2012/052583
(87) Internationale Veröffentlichungsnummer: WO 2012/139795

(56) Entgegenhaltungen:
- EP-A1- 2 211 089
- EP-A2- 1 371 605
- EP-A2- 1 662 585
- WO-A1-02/44790
- JP-A- 2011 065 766
- US-A- 6 091 537
- US-A1- 2002 105 699
- US-A1- 2006 001 055

## Beschreibung

### Stand der Technik

Die vorliegende Erfindung bezieht sich auf eine Vorrichtung zum Beeinflussen einer Abstrahlcharakteristik einer lichtemittierenden Diode, auf ein Lichtsystem mit veränderbarer Abstrahlcharakteristik sowie auf ein Verfahren zum Beeinflussen einer Abstrahlcharakteristik einer lichtemittierenden Diode.

Eine lichtemittierende Diode strahlt Licht aus einem elektrisch angeregten Substrat in der Regel ungerichtet ab. Durch ein Umgießen des Substrats mit einer Linse kann das Licht zu einem Lichtkegel konzentriert werden. Der Lichtkegel weist eine feste Hauptabstrahlrichtung von der lichtemittierenden Diode auf.

Die WO-2005040036-A1 beschreibt einen variablen optischen Abschwächer für ein optisches Kommunikationssystem mit einem mikroelektromechanischen Antrieb, der einen Betätigungsarm steuerbar ablenkt, um einen Photodetektor vor einem lichtemittierenden Teil einer optischen Faser abzudecken.

### Offenbarung der Erfindung

Vor diesem Hintergrund wird mit der vorliegenden Erfindung eine Vorrichtung zum Beeinflussen einer Abstrahlcharakteristik einer lichtemittierenden Diode, ein Lichtsystem mit veränderbarer Abstrahlcharakteristik sowie ein Verfahren zum Beeinflussen einer Abstrahlcharakteristik einer lichtemittierenden Diode gemäß den Hauptansprüchen vorgestellt. Vorteilhafte Ausgestaltungen ergeben sich aus den jeweiligen Unteransprüchen und der nachfolgenden Beschreibung.

Aus der EP 2 211 089 A1 ist eine Vorrichtung zur Erzeugung eines Mischfarben-Lichtes bekannt, bei dem das Licht von wenigstens zwei Lichtquellen unterschiedlicher Farbe verbunden und anschließend mittels einer Linsenstruktur abgebildet wird. Die Linse selber ist manuell oder motorisch bewegbar.

Aus der WO 02/44790 A1 ist ein mikrooptisches System für einen Autofokusscanner bekannt, der eine Lichtquelle, ein mikrooptisches Element angeordnet benachbart zu der Lichtquelle und einen Aktuator umfasst. Der Aktuator ist zu einer Verschiebung des als Mikrolinse ausgebildeten optischen Elements ausgebildet.

Aus der US 2002/0105699 A1 ist ein integriertes optisches mikroelektronisches System bekannt, bei dem Licht von einer Laserarray über ein Mikrolinsen-Array abgebildet wird. Das Mikrolinsen-Array kann dabei mikromechanisch bewegt werden.

Aus der US 6,091,537 A ist eine elektrisch angesteuerte Mikrolinsenvorrichtung bekannt.

Aus der EP 1 371 605 A2 ist ein mikrooptisches System bekannt, bei dem über eine Strukturierung mikro-optische Reliefstrukturen in ein mikromechanisches optisches Element ein strukturiert werden.

Aus der US 2006/0001055 A1 ist eine Leuchtdiode und ein Herstellungsverfahren für die Leuchtdiode bekannt.

Derzeit befinden sich lichtemittierende Dioden oder Leuchtdioden (LEDs - light emitting diode) in einer Übergangsphase vom Einsatz in speziellen Anwendungen hin zu einem weitreichenden Ersatz von konventionellen Leuchtmitteln wie Glühlampen und Leuchtstoffröhren in allen Beleuchtungseinrichtungen, beispielsweise im Verkehr, Deckenleuchten und Wandleuchten oder Straßenlampen. LEDs sind sehr kleine und nahezu punktförmige Lichtquellen. Erfindungsgemäß werden LEDs nicht nur in Funktion punktförmiger Lichtquellen, z.B. als Lichterkette, und nicht nur in Verbindung mit konventionellen großen optischen Systemen, wie Linsen, Spiegeln oder Reflektoren verwendet, sondern mit einer aktuierten Optik versehen, um variable Lichtverteilungen zu ermöglichen. Damit kann der Größenvorteil der LED ausgenutzt werden. Dies ist z.B. bei Autoscheinwerfern vorteilhaft. Durch die Anwendung von Mikrosystemtechnik werden spezielle Anwendungsgebiete für LEDs erschlossen. So können steuerbare Autoscheinwerfer auf LED Basis geschaffen werden.

Auch können LEDs in einer Lampe nebeneinander auf einer Fläche angeordnet sein, die die bei LEDs notwendige Rückseitenkühlung übernehmen kann. Hier lassen sich sehr flache, unauffällig in Wand und Decke integrierbare Lampen realisieren. Eine Lichtabstrahlung kann hierbei veränderbar gerichtet werden.

Der hier vorgestellte Ansatz realisiert sehr kleine, in ihrer Lichtverteilung aber sehr variable und von außen steuerbare Lampen auf Basis von LEDs und einer ebenfalls miniaturisierten Optik. Die Baugröße der LEDs wird dabei nicht nennenswert vergrößert.

Die Erfindung basiert auf der Erkenntnis, dass von einer lichtemittierenden Diode (LED, Leuchtdiode) ausgehendes Licht durch ein vor der lichtemittierenden Diode angeordnetes bewegliches optisches Element beeinflusst oder geformt werden kann. Dazu kann das optische Element mittels einer Einrichtung zum Bewegen des optischen Elements relativ zur lichtemittierenden Diode in unterschiedliche Positionen bewegt werden. Beispielsweise kann ein seitlicher Abstrahlwinkel beeinflusst werden, wenn das optische Element seitlich zum ausgehendenden Licht der Leuchtdiode verschoben wird. Ein Öffnungswinkel eines durch das optische Element geformten Lichtkegels kann durch einen veränderten Abstand zwischen der lichtemittierenden Diode und dem optischen Element vergrößert oder verkleinert werden. Wird eine mikromechanische Einrichtung zum Bewegen des optischen Elements eingesetzt, so kann eine Baugröße der gesamten Anordnung gering gehalten werden. Durch das optische Element kann mit einer unbeweglichen Lichtquelle ein Raum vor der Lichtquelle mit unterschiedlichen Lichtszenen beleuchtet werden.

Die vorliegende Erfindung schafft eine Vorrichtung zum Beeinflussen einer Abstrahlcharakteristik einer lichtemittierenden Diode, wobei die Vorrichtung die folgenden Merkmale aufweist:
Ein optisches Element, das relativ zur lichtemittierenden Diode zwischen einer ersten Position und zumindest einer weiteren Position beweglich anordenbar ist, und dazu ausgebildet ist, um eine erste Lichtverteilung des von der lichtemittierenden Diode abgestrahlten Lichts zu bewirken, wenn das optische Element in der ersten Position angeordnet ist, und um eine weitere Lichtverteilung des von der lichtemittierenden Diode abgestrahlten Lichts zu bewirken, wenn das optische Element in der zumindest einen weiteren Position angeordnet ist; und
zumindest ein mikromechanischer Aktuator zum Bewegen des optischen Elements zwischen der ersten und der zumindest einen weiteren Position, um die Abstrahlcharakteristik zu beeinflussen.

Unter einer Abstrahlcharakteristik einer lichtemittierenden Diode kann eine Form und/oder eine Richtung eines Lichtkegels oder einer Leuchtdichteverteilung verstanden werden, welche die lichtemittierende Diode abstrahlt. Eine lichtemittierende Diode kann ein Halbleiterbauteil sein, das aufgrund eines angelegten Stromflusses Licht aus einem Substrat des Halbleiterbauteils abstrahlt. Die lichtemittierende Diode kann auch als Leuchtdiode oder als LED bezeichnet werden. Ein optisches Element kann das Licht der Diode durch optische Effekte, wie beispielsweise reflektieren, brechen, beugen und streuen zu einer Lichtverteilung formen. Dabei kann ein Einfallswinkel des Lichts der Diode in das optische Element Einfluss auf einen Ausfallswinkel des Lichts des Lichtkegels aus dem optischen Element nehmen. Wenn das optische Element im Licht der lichtemittierenden Diode bewegt wird kann sich der Einfallswinkel des Lichts ändern. Dadurch kann sich auch der Ausfallswinkel des Lichts ändern. Die Abstrahlcharakteristik kann eine Gesamtheit der Ausfallswinkel des Lichts aus dem optischen Element und/oder der lichtemittierenden Diode repräsentieren. Die Lichtverteilung kann Bereiche mit einer hohen Lichtintensität, sowie Bereiche mit einer niedrigen Lichtintensität aufweisen. Die erste Lichtverteilung kann eine andere Abstrahlcharakteristik aufweisen, als die weitere Lichtverteilung. Unter einem mikromechanischen Aktuator kann eine Struktur verstanden werden, deren Komponenten kleinste Abmessungen, beispielsweise im Mikrometerbereich aufweisen. Der Aktuator kann beispielsweise aus Silizium oder einem ähnlichen Werkstoff, wie z.B. Siliziumcarbid, Galliumarsenid oder Galliumnitrid sein. Ein bewegliches Ende des mikromechanischen Aktuators kann durch ein Einwirken von elektrischer Energie zwischen zumindest zwei Positionen bewegt werden. Beispielsweise kann das Ende des mikromechanischen Aktuators durch ein angelegtes bestimmtes Spannungsniveau eine bestimmte Lage zwischen den zumindest zwei Positionen einnehmen. Das bewegliche Ende des mikromechanischen Aktuators kann mit dem optischen Element verbunden sein. Ein anderes Ende des mikromechanischen Aktuators kann beispielsweise mit einer Platine der lichtemittierenden Diode verbunden werden. So kann der mikromechanischen Aktuator das optische Element relativ zur Leuchtdiode bewegen.

Entsprechend einer weiteren Ausführungsform der vorliegenden Erfindung kann der Aktuator dazu ausgebildet sein, um das optische Element senkrecht oder alternativ bzw. ergänzend parallel zu mindestens einer Haupterstreckungsebene der lichtemittierenden Diode zu bewegen. Unter einer senkrechten Bewegung des optischen Elements kann ein Vergrößern oder Verkleinern eines Abstands zwischen einer Haupterstreckungsebene des optischen Elements und einer Haupterstreckungsebene der lichtemittierenden Diode verstanden werden. Bei einem großen Abstand kann das Licht beispielsweise in das optische Element einfallen und als Lichtkegel mit einer kleinen Öffnungsweite aus dem optischen Element austreten. Bei einem kleinen Abstand kann das Licht beispielsweise als Lichtkegel mit einer großen Öffnungsweite aus dem optischen Element austreten. Dadurch kann der Lichtkegel "breiter" werden, wenn das optische Element näher an der lichtemittierenden Diode ist. Durch eine Bewegung parallel zur Haupterstreckungsebene der lichtemittierenden Diode kann ein Abstand zwischen einer optischen Achse des optischen Elements und einer Hauptabstrahlachse der lichtemittierenden Diode verändert werden. Durch eine Bewegung des optischen Elements senkrecht oder parallel zu der Haupterstreckungsebene der Leuchtdiode, oder einer Kombination der Bewegungsrichtungen kann der durch das optische Element geformte Lichtkegel in seiner Abstrahlcharakteristik beeinflusst werden.

Das optische Element kann eine Linse, ein optisches Gitter oder eine Spiegeloptik sein. Unter einer Linse kann ein optisch wirksames Element mit zwei lichtbrechenden Flächen verstanden werden, wobei mindestens eine der zwei lichtbrechenden Flächen konvex oder konkav gewölbt ist. Die lichtbrechenden Flächen können in Teilflächen unterteilt sein. Beispielsweise kann die Linse eine Fresnel-Linse sein. Unter einer Spiegeloptik kann eine reflektierende Fläche mit kleinsten Abmessungen verstanden werden. Die reflektierende Fläche kann in Teilflächen unterteilt sein. Die reflektierende Fläche kann planar, konvex oder konkav sein. Beispielsweise kann die Spiegeloptik metallisierte Flächen aufweisen, an denen das Licht der lichtemittierenden Diode reflektiert werden kann, um den Lichtkegel zu bilden. Eine Fresnel-Linse kann sehr dünn und damit leicht hergestellt werden, und kann daher aufgrund geringer Trägheitsmasse besonders schnell bewegt werden. Eine Spiegeloptik kann in dem gleichen Arbeitsdurchlauf hergestellt werden, in dem die mikromechanischen Aktuatoren hergestellt werden.

Der mikromechanische Aktuator kann als elektrostatischer, thermischer, piezoelektrischer oder magnetischer Aktuator ausgeführt sein. Auch kann der Aktuator ausgebildet sein, um eine Kombination aus elektrostatischen, thermischen, piezoelektrischen und magnetischen Prinzipien nutzen. Dabei kann der Aktuator eine Kombination aus allen oder einigen der genannten Prinzipien umsetzen. Der Antrieb kann ausgebildet sein, um die Prinzipien für einen Antrieb des optischen Elements zu nutzen. Alternativ oder zusätzlich kann der Antrieb ausgebildet sein, um die Prinzipien für eine Lagedetektion des optischen Elements zu nutzen.

Der Aktuator kann einen Lagerhebel zum Bewegen des optischen Elements in zumindest einer Raumrichtung aufweisen. Unter einem Lagerhebel kann ein mechanisches Bauteil zum Verbinden des Aktuators mit dem optischen Element verstanden werden. Der Lagerhebel kann aufgrund seiner Form, beispielsweise einer L-Form, eine Bewegung des Aktuators in zumindest einer Raumrichtung auf das optische Element übertragen. Beispielsweise kann der Lagerhebel Bewegungen in drei Raumrichtungen auf das optische Element übertragen. In diesem Fall kann der Aktuator ausgebildet sein, das optische Element in drei Raumrichtungen zu bewegen.

Der Aktuator weist erfindungsgemäß ein Reibungslager als Schnittstelle zwischen dem optischen Element und dem Aktuator auf. Unter einem Reibungslager kann eine Lagerstelle verstanden werden, die dazu ausgebildet ist, um das optische Element zumindest in einer Raumrichtung durch Reibung zu halten, wenn der Aktuator das optische Element nicht beschleunigt, bewegt oder mit einer Kraft beaufschlagt. Bei miniaturisierten optischen Elementen und Aktuatoren können als benötigte Reibungskraft insbesondere Oberflächenkräfte an definierten Auflagestellen genutzt werden. In der Silizium-Mikrosystemtechnik ist dieser Effekt als Störphänomen ("sticking") bekannt. Ein solches Reibungslager lässt sich auch in Kombination mit einer Trägheitsbewegung einsetzen: Wenn sich der Aktuator mit einer hohen Beschleunigung bewegt, dann kann das optische Element in der zumindest einen Raumrichtung durch seine Massenträgheit auf einem Reibungslager gleiten, und eine Position auf dem Reibungslager verändern. Wenn der Aktuator das Reibungslager mit einer geringen Beschleunigung langsam bewegt, dann kann das optische Element in der zumindest einen Raumrichtung die Position auf dem Reibungslager durch eine Reibungskraft beibehalten. Kehrt der Aktuator nach einer Beschleunigung, die eine Verschiebung des optischen Elements bewirkt, wieder mit einer Bewegung, bei der sich das optische Element nicht mitbewegt in eine Ausgangslage zurück, so hat das optische Element durch die Verschiebung im Vergleich zu einem Zustand vor der Beschleunigung seine Position relativ zu der lichtemittierenden Diode und dem Aktuator verändert. Durch mehrfaches Wiederholen dieses Zyklus kann das optische Element über einen Bereich verschoben werden, der weit größer ist als die maximal mögliche Reichweite aus der Einzelbewegung des Aktuators.

Wird der Aktuator so ausgelegt, dass er in mehreren Raumrichtungen bewegt werden kann, kann vorteilhafterweise durch eine Bewegung in einer ersten Richtung ein optisches Element aus einer Grundposition in dieser ersten Richtung angehoben werden, z.B. entgegen einer Federkraft, wodurch eine Reibungslagerung aufgehoben wird und ein leichtes Verschieben in mindestens einer weiteren Raumrichtung ermöglicht wird. Nach der Positionierung wird die Grundposition in der ersten Richtung wieder eingenommen, worauf sich durch die Reibung und ggf. durch eine Federkraft wieder eine stabile Position ergibt.

Gemäß einer weiteren Ausführungsform der vorliegenden Erfindung umfasst die Vorrichtung einen, die lichtemittierende Diode umschließenden Rahmen, wobei der Aktuator mit dem Rahmen verbunden ist. Unter einem Rahmen kann ein Bauteil zum Befestigen der Vorrichtung an der lichtemittierenden Diode verstanden werden. Der Rahmen kann die Diode in einer Haupterstreckungsebene der Diode ganz oder teilweise umschließen. Der Rahmen kann den zumindest einen Aktuator senkrecht zu einer Bewegungsrichtung des Aktuators abstützen. Der zumindest eine Aktuator und der Rahmen können einstückig ausgeführt sein. Die mikromechanische Struktur des Aktuators kann aus dem Rahmen herausgearbeitet sein. Durch den Rahmen kann die Vorrichtung eine hohe Stabilität aufweisen. Der Rahmen kann eine Klebefläche oder eine Befestigungsfläche aufweisen, um fest mit der lichtemittierenden Diode verbunden zu werden. Vorteilhafterweise wird die Verbindung zwischen lichtemittierender Diode und dem Rahmen nicht am Einzelbauelement durchgeführt sondern bereits auf Waferebene, z.B. in Form eines Waferbondens. Dabei kann das Waferbonden auch in einer Vorstufe des Aktuators stattfinden, bei der die Rahmen noch nicht als einzelne Bauelemente sondern nur als Bestandteil eines Wafers vorliegen. Der Rahmen kann Führungsflächen zum Führen des optischen Elements in zumindest einer Raumrichtung aufweisen.

Entsprechend einer weiteren Ausführungsform der vorliegenden Erfindung kann der Rahmen zumindest einen Versorgungsleiter für den Aktuator, oder alternativ bzw. ergänzend die lichtemittierende Diode aufweisen. Unter einem Versorgungsleiter kann eine elektrische Leiterbahn verstanden werden. Durch eine Integration eines Versorgungsleiters in den Rahmen kann der zumindest eine Aktuator besonders einfach kontaktiert werden. Wenn ein Versorgungsleiter für die lichtemittierende Diode in den Rahmen integriert ist, kann die lichtemittierende Diode im gleichen Arbeitsschritt elektrisch kontaktiert werden, wie der zumindest eine Aktuator. Der Rahmen kann dazu ausgebildet sein, um bereichsweise elektrisch leitend mit der lichtemittierenden Diode verbunden zu werden. Vorteilhafterweise wird der Rahmen so ausgeführt, dass er auch über eine hohe thermische Leitfähigkeit verfügt, um Verlustleistung gezielt abführen oder verteilen zu können.

Ferner kann der Rahmen eine Auflagefläche für das optische Element aufweisen, die dazu ausgebildet ist, das optische Element verschiebbar zu lagern. Dabei kann zwischen dem optischen Element und der Auflagefläche eine Haltekraft wirken. Die Haltekraft kann durch Adhäsion und/oder Kohäsion bewirkt werden. Zusätzlich oder alternativ kann die Vorrichtung eine Feder aufweisen und die Haltekraft kann durch die Feder bewirkt werden. Unter einer Auflagefläche kann eine Kontaktfläche zwischen dem optischen Element und dem Rahmen verstanden werden, auf der das optische Element in einem Ruhezustand in Kontakt mit dem Rahmen steht. Das optische Element kann auf dem Rahmen durch eine Reibungslagerung angeordnet sein. Das optische Element kann zum Bewegen durch den Aktuator beispielsweise von der Auflagefläche angehoben werden, bewegt werden und erneut auf der Auflagefläche abgesetzt werden, wobei das optische Element dann eine veränderte Position auf der Auflagefläche einnehmen kann. Zwischen dem optischen Element und der Auflagefläche kann beispielsweise eine Haftreibung bestehen, die durch eine Oberflächenbeschaffenheit der Auflagefläche und/oder des optischen Elements beeinflusst werden kann. Zusätzlich kann das optische Element von einer Feder oder Druckfeder auf die Auflagefläche aufgedrückt werden. In diesem Fall kann der Aktuator das optische Element mit großer Dynamik bewegen, da die Feder das optische Element gegen ein ungewolltes "Davonfliegen" sichern kann. Ebenso kann das optische Element durch eine Flüssigkeitsreibung und/oder Oberflächenspannung auf der Auflagefläche gehalten werden. In diesem Fall können physikalische Eigenschaften eines Kontaktfluids zwischen dem optischen Element und dem Rahmen Widerstandskräfte bewirken, die der Aktuator zum Bewegen des optischen Elements überwinden kann. Eine Oberflächenbeschaffenheit des optischen Elements und/oder des Rahmens kann Anziehungskräfte auf molekularer Basis bewirken, die das optische Element sicher halten, wenn das optische Element in Kontakt mit der Auflagefläche steht. Der Aktuator kann die Anziehungskräfte überwinden und das optische Element bewegen, um das optische Element an einer anderen Stelle erneut auf dem Rahmen abzusetzen. Dadurch kann mit einer Mehrzahl von kleinen aufeinanderfolgenden Bewegungsschritten des Aktuators das optische Element über einen großen Verstellweg bewegt werden.

In einer Ausführungsform kann die Vorrichtung einen ersten Aktuator, der zum Bewegen des optischen Elements mit einer ersten Ecke des optischen Elements verbunden ist, einen zweiten Aktuator, der zum Bewegen des optischen Elements mit einer zweiten Ecke des optischen Elements verbunden ist, und einen dritten Aktuator, der zum Bewegen des optischen Elements mit einer dritten Ecke des optischen Elements verbunden ist, aufweisen. Durch eine Verbindung der Aktuatoren mit dem optischen Element an drei Ecken kann das optische Element besonders einfach und mit einer besonders geringen Anzahl von Aktuatoren bewegt werden. Daher können sowohl lineare Bewegungen, als auch Kippbewegungen ausgeführt werden. Das optische Element kann beispielsweise dreieckig oder sechseckig ausgeführt sein. Dadurch kann eine besonders dichte Packungsdichte von mehreren Leuchtdioden nebeneinander erreicht werden. Bei einer dreieckigen Anordnung kann insbesondere auch ein Sägen oder teilweises oder vollständiges Trennen von Bauelementen auf Waferebene erfolgen, wofür nur parallele Bewegungen der Trennvorrichtung in drei Richtungen notwendig sind. Um dieses Trennen zu vereinfachen kann die Anordnung von Leuchtdioden und optischen Elementen bzw. Aktorik durch eine feststehende, lichtdurchlässige Schicht abgedeckt werden, in die weitere optische Elemente, z.B. Filter, Linsen, und elektrische Elemente wie z.B. Kontaktpads eingearbeitet sein können.

Weiterhin schafft die vorliegende Erfindung ein Lichtsystem mit veränderbarer Abstrahlcharakteristik, mit folgenden Merkmalen:
einer lichtemittierenden Diode;
einer Vorrichtung zum Beeinflussen einer Abstrahlcharakteristik einer lichtemittierenden Diode gemäß dem hier vorgestellten Ansatz, wobei ein erstes Ende des Aktuators mit dem optischen Element, und ein zweites Ende des Aktuators mit der lichtemittierenden Diode verbunden ist.

Bei einem Lichtsystem kann ein Aktuator dazu ausgebildet sein, um einen Zwischenraum zwischen der lichtemittierenden Diode und dem optischen Element ansprechend auf ein Ansteuersignal zu verändern. Der Aktuator kann auch dazu ausgebildet sein, den Abstand ohne dass Ansteuersignal konstant zu halten. Der Aktuator kann ansprechend auf einen Verschiebesignal das optische Element gegenüber der lichtemittierenden Diode in einer Verschiebeebene verschieben. Der Aktuator kann auch dazu ausgebildet sein, das optische Element in einer Position zu halten, wenn der Aktuator von keinem Verschiebesignal angesteuert wird. Das optische Element kann auch durch zumindest eine Feder in einer Position gehalten oder geklemmt werden.

Weiterhin umfasst die Erfindung auch ein Verfahren zum Beeinflussen einer Abstrahlcharakteristik einer lichtemittierenden Diode eines Lichtsystems mit der lichtemittierenden Diode, einem optischen Element und zumindest einem mikromechanischen Aktuator, wobei das optische Element relativ zur lichtemittierenden Diode zwischen einer ersten Position und zumindest einer weiteren Position beweglich angeordnet ist, und dazu ausgebildet ist, um eine erste Lichtverteilung des von der lichtemittierenden Diode abgestrahlten Lichts zu bewirken, wenn das optische Element in der ersten Position angeordnet ist, und um eine weitere Lichtverteilung des von der lichtemittierenden Diode abgestrahlten Lichts zu bewirken, wenn das optische Element in der zumindest einen weiteren Position angeordnet ist, und wobei der Aktuator dazu ausgebildet ist, um das optische Element zwischen der ersten und der zumindest einen weiteren Position zu bewegen, wobei das Verfahren den folgenden Schritt aufweist:
Ansteuern des zumindest einen Aktuators mit einem Ansteuersignal zum Bewegen des optischen Elements, um die Abstrahlcharakteristik zu beeinflussen.

Unter einem Ansteuersignal kann ein elektrisches Signal verstanden werden. Das Ansteuersignal kann den Aktuator beispielsweise elektrostatisch, elektrothermisch, elektromagnetisch oder piezoelektrisch betätigen. Das Ansteuersignal kann von einer Ansteuervorrichtung an den Aktuator bereitgestellt werden. Umfasst das Lichtsystem mehrere Dioden, so kann das Ansteuersignal an die entsprechenden Aktuatoren der Dioden bereitgestellt werden.

Die Erfindung wird nachstehend anhand der beigefügten Zeichnungen beispielhaft näher erläutert. Es zeigen:
- Fig. 1: eine Darstellung einer Vorrichtung zum Beeinflussen einer Abstrahlcharakteristik einer lichtemittierenden Diode gemäß einem Ausführungsbeispiel der vorliegenden Erfindung;
- Fig. 2: ein Ablaufdiagramm eines Verfahrens zum Beeinflussen einer Abstrahlcharakteristik einer lichtemittierenden Diode gemäß einem Ausführungsbeispiel der vorliegenden Erfindung;
- Fig. 3: eine Darstellung einer lichtemittierenden Diode;
- Fig. 4: eine Darstellung eines Lichtsystems mit veränderbarer Abstrahlcharakteristik gemäß einem Ausführungsbeispiel der vorliegenden Erfindung ;
- Fig. 5: eine Darstellung eines Lichtsystems mit veränderbarer Abstrahlcharakteristik gemäß einem Ausführungsbeispiel der vorliegenden Erfindung;
- Fig. 6a und 6b: Darstellungen eines Lagerhebels und einer Lagerstelle im optischen Element gemäß einem Ausführungsbeispiel der vorliegenden Erfindung;
- Fig. 7: eine Darstellung eines Lichtsystems mit veränderbarer Abstrahlcharakteristik mit drei Aktuatoren gemäß einem Ausführungsbeispiel der vorliegenden Erfindung;
- Fig. 8: eine Darstellung eines Lichtsystems mit veränderbarer Abstrahlcharakteristik und Reiblagerung gemäß einem Ausführungsbeispiel der vorliegenden Erfindung;
- Fig. 9: eine Darstellung eines Lichtsystems mit veränderbarer Abstrahlcharakteristik und Federlagerung gemäß einem Ausführungsbeispiel der vorliegenden Erfindung; und
- Fig. 10: eine Darstellung eines Lichtsystems mit veränderbarer Abstrahlcharakteristik und fester Lagerung gemäß einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

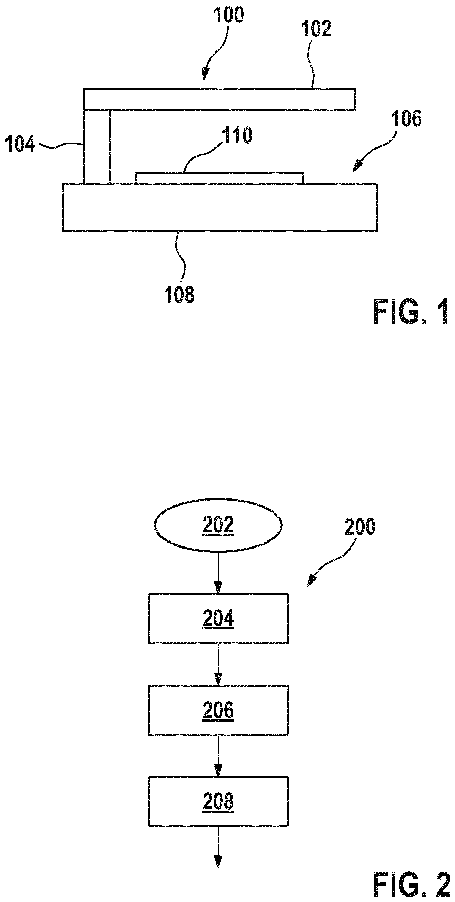

Fig. 1 zeigt eine Darstellung einer Vorrichtung 100 zum Beeinflussen einer Abstrahlcharakteristik einer lichtemittierenden Diode 106 gemäß einem Ausführungsbeispiel der vorliegenden Erfindung. Die Vorrichtung 100 weist ein optisches Element 102 sowie zumindest einen mikromechanischen Aktuator 104 zum Bewegen des optischen Elements 102 auf. Die lichtemittierende Diode 106 weist eine Trägerplatine 108 und ein lichtemittierendes Substrat 110 auf. Wenn das Substrat 110 durch einen elektrischen Strom zwischen einer Kathode und einer Anode der Diode 106 zum Leuchten angeregt wird, emittiert das Substrat 110 Licht in alle Richtungen über Oberflächen des Substrats 110. Da das Substrat 110 eine große Oberfläche auf einer von der Platine 108 abgewandten Seite aufweist, emittiert das Substrat 110 in der Regel dort den größten Anteil des Lichts. Dieses Licht breitet sich in der abgebildeten Darstellung näherungsweise halbkugelförmig vom Substrat 110 aus. Nachdem das Licht einen Zwischenraum zwischen dem Substrat 110 und dem optischen Element 102 überwunden hat, dringt das Licht in das optische Element 102 ein. Das optische Element 102 ist dazu ausgebildet, um das Licht abzulenken und zu einem Lichtkegel zu formen. Der Lichtkegel tritt aus dem optischen Element 102 auf einer, von der lichtemittierenden Diode 106 abgewandten Seite aus dem optischen Element 102 aus. Wenn das optische Element 102 eine erste Position relativ zur lichtemittierenden Diode 106 aufweist, dann weist der Lichtkegel eine erste Lichtverteilung auf. Wenn das optische Element 102 eine, von der ersten Position unterschiedliche weitere Position relativ zur lichtemittierenden Diode 106 aufweist, dann weist der Lichtkegel eine, von der ersten Lichtverteilung unterschiedliche weitere Lichtverteilung auf. Das optische Element 102 ist durch den mikromechanischen Aktuator 104 mit der lichtemittierenden Diode 106 verbunden. Der Aktuator 104 ist an der Platine 108 befestigt. Der mikromechanischen Aktuator 104 ist dazu ausgebildet, um das optische Element 102 zwischen der ersten Position und zumindest der weiteren Position zu bewegen. Dazu kann der Aktuator 104 durch ein Ansteuersignal angeregt werden. In einer anderen, nicht gezeigten Anordnung kann das Substrat 110 auch bevorzugt Licht in eine lichtdurchlässige Platine 108 abstrahlen, so dass der Lichtkegel auf einer vom Substrat abgewandten Seite oder neben dem Substrat aus der Platine austritt. Entsprechend kann die Anordnung des Aktuators 104 und des optischen Elementes 102 angepasst werden.

Fig. 2 zeigt ein Ablaufdiagramm eines Verfahrens 200 zum Beeinflussen einer Abstrahlcharakteristik einer lichtemittierenden Diode gemäß einem Ausführungsbeispiel der vorliegenden Erfindung. Bei der Diode kann es sich um die in Fig. 1 gezeigte Diode handeln. Das Verfahren 200 weist einen Schritt des Anforderns 202, einen Schritt des Ermittelns 204, einen Schritt des Bestimmens 206 sowie einen Schritt des Ansteuerns 208 auf. Ansprechend auf das Anfordern 202 einer Abstrahlcharakteristik für die lichtemittierende Diode, beispielsweise durch ein Steuergerät, wird in dem Schritt des Ermittelns 204 eine Position für das optische Element zum Anpassen des optischen Elements an die Abstrahlcharakteristik ermittelt. Basierend auf der ermittelten Position wird in dem Schritt des Bestimmens 206 ein Aktuator-Verstellungsweg zum Bewegen des optischen Elements in die ermittelte Position bestimmt. Im Schritt des Ansteuerns 208 wird der Aktuator mit einem Ansteuersignal zum Verstellen des Aktuators um den Aktuator-Verstellungsweg angesteuert. Ansprechend auf das Ansteuersignal bewegt der Aktuator das optische Element um den Aktuator-Verstellungsweg in die ermittelte Position. Sobald sich das optische Element in der ermittelten Position befindet, weist die lichtemittierende Diode die angeforderte Abstrahlcharakteristik auf. Das Ansteuern 208 kann dabei wie oben beschrieben ein wiederholter Prozess sein, bei dem der Aktuator mehrfach eine Bewegung durchführt, bei der das optische Element jeweils schrittweise verschoben wird. Vorteilhaft ist die Durchführung einer Initialisierung, bei der das System erst in eine definierte Ausgangsposition gebracht wird, aus der heraus dann eine gezielte Positionierung erfolgt.

Die Schritte 202, 204, 206, 208 können wiederholt ausgeführt werden. So kann ansprechend auf ein weiteres Anfordern einer weiteren Abstrahlcharakteristik für die lichtemittierende Diode eine weitere Position für das optische Element ermittelt werden und basierend auf der weiteren Position ein weiterer Aktuator-Verstellungsweg bestimmt werden, um das optische Element in die weitere Position zu bewegen. Sobald sich das optische Element in der weiteren Position befindet, weist die lichtemittierende Diode die angeforderte weitere Abstrahlcharakteristik auf.

Die gewünschte Abstrahlcharakteristik kann beispielsweise durch einen Benutzer über eine Benutzerschnittstelle oder durch ein Sensorsignal, beispielsweise eines die Helligkeit im Umfeld der Leuchtdiode erfassenden Sensors, vorgegeben werden.

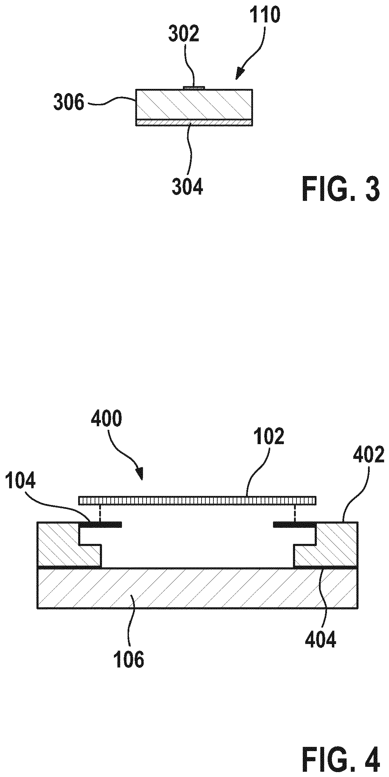

Fig. 3 zeigt eine Darstellung eines LED Plättchens 110, Chip oder "bare die". Das LED Plättchen 110 besteht aus lumineszentem Substrat. Das LED Plättchen 110 weist eine quaderförmige Gestalt mit quadratischer Grundfläche auf. Dieses Ausführungsbeispiel zeigt einen LED Chip mit einer Grundfläche von etwa 400 µm mal 400 µm. Auf einer Oberseite weist das LED Plättchen 110 eine dielektrische Passivierung auf. Diagonal über die Oberseite weist das LED Plättchen 110 Kontaktfinger auf, die an einem Schnittpunkt in der Mitte der Oberseite von einem runden Bond Pad 302, z.B. aus Gold mit einem Durchmesser von etwa 100 µm verbunden sind. Eine Unterseite des LED Plättchens 110 weist eine rückseitige Metallisierung 304 (Backside Metallization) auf. In Fig. 3 ist ein Schnitt durch das LED Plättchen 110 (Die Cross Section) senkrecht zur Oberfläche dargestellt. Das LED Plättchen 110 weist eine Dicke t 306 von etwa 200 µm auf. Auf der Oberseite befindet sich als Kathode oder Minuspol das Gold Bond Pad 302. Auf der Unterseite befindet sich als Anode oder Pluspol die rückseitige Metallisierung 304 mit einer Dicke von wenigen Mikrometern AuSn (Gold-Zinn). Das LED Plättchen 110 kann Teil der in Fig. 1 gezeigten Diode sein.

Das LED Plättchens 110, wie in Fig. 3 dargestellt, kann auf einem Sockel mit Gehäuse befestigt werden. Die Größe liegt dann typischerweise in einem Bereich von etwa 4mm mal 4mm mal 2mm. Der Sockel kann auf der Oberseite zwei auch zum Golddrahtbonden geeignete Prüfkontakte aufweisen. Mittig auf dem Sockel über dem LED Plättchen 110 kann sich eine Linse aus durchsichtigem Kunststoff befinden, die das LED Plättchen 110 vor mechanischen Einflüssen schützt. Auf der Unterseite kann der Sockel zwei Lötkontakte sowie eine Wärmesenke zwischen den zwei Lötkontakten aufweisen. Die zwei Prüfkontakte auf der Oberseite können jeweils in den oberen Ecken des Sockels angeordnet sein. Zentral auf dem Sockel kann sich das LED Plättchen 110 befinden. 110. Die Linse kann sich halbkreisförmig über dem LED Plättchen 110 erheben. Die zwei unterseitigen Lötkontakte können entlang eines linken Randes und eines rechten Randes des Sockels angeordnet sein. Die Wärmesenke kann mittig parallel zu den Lötkontakten, gegenüber des LED Plättchens 110 angeordnet sein und von einem oberen Rand des Sockels zu einem unteren Rand des Sockels reichen.

Eine für Beleuchtungszwecke in Frage kommende Hochleistungs-LED hat als reines Halbleiter-Die 110 oder Substrat 110 eine Größe von typischerweise mehreren hundert µm und eine Dicke von ca. 200 µm, wie in Fig. 3 dargestellt. In der Regel wird dieses Die 110 über einen Rückseitenkontakt 304 auf einen Sockel montiert und über einen Drahtbond 302 auf der Vorderseite angeschlossen. Der Sockel übernimmt die Wärmeableitung auf die Rückseite und die elektrische Kontaktierung. Die Lichtabstrahlung kann über eine auf dem Sockel fest aufgebrachte Linse geformt oder modifiziert werden. Diese meist aus einem Polymer bestehende Schicht schützt gleichzeitig das Die 110 und eine eventuell auf das Die 110 aufgebrachte Leuchtstoffschicht. Durch diesen Aufbau mit einer einfachen Linse ist das Volumen der LED um einen Faktor 1000 vergrößert. Der Aufbau erfordert für die Realisierung einer Beleuchtungseinrichtung noch weitere deutlich größere Komponenten wie z.B. zusätzliche Linsen, Streuscheiben und Reflektoren.

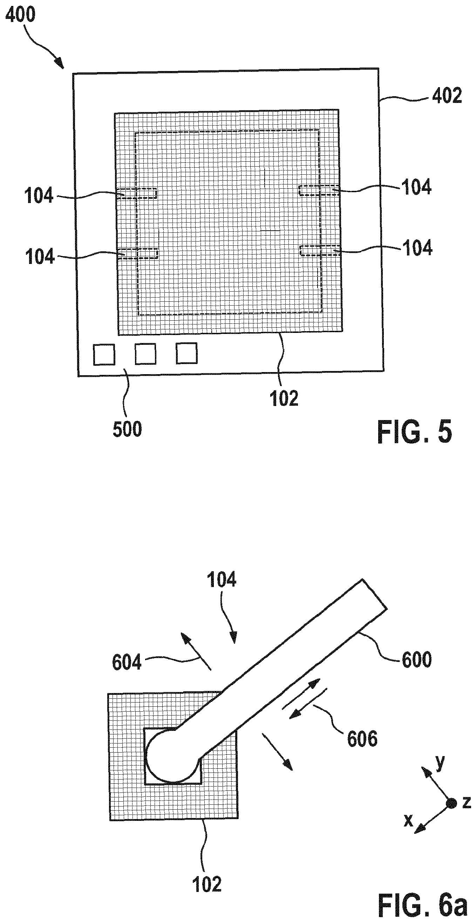

Die Figuren 4 und 5 zeigen einen Schnitt und eine Draufsicht eines Lichtsystems 400 mit veränderbarer Abstrahlcharakteristik gemäß einem Ausführungsbeispiel der vorliegenden Erfindung. Mit anderen Worten zeigen die Figuren 4 und 5 ein Beispiel für eine Realisierung einer LED-Optik mit direkt aufeinander gebondeter LED 106 und Rahmen 402 mit Aktuatoren 104.

Fig. 4 zeigt eine Schnittdarstellung durch das Lichtsystem 400. Auf eine lichtemittierende Diode 106 ist ein Rahmen 402 mit mikromechanischen Aktuatoren 104 zum Bewegen eines optischen Elements 102 befestigt. Der Rahmen 402 ist über eine Bondverbindung 404 direkt mit einer Trägerplatine der lichtemittierenden Diode 106 verbunden. Der Rahmen 402 weist eine umlaufende Aussparung auf, in die die Aktuatoren 104 das optische Element 102 bewegen können, um einen vertikalen Abstand zwischen dem optischen Element 102 und der lichtemittierenden Diode 106 zu verändern. Das optische Element 102, beispielsweise eine Fresnel-Linse, ist fest an den Aktuatoren 104 angebracht oder ist für einen Trägheitsantrieb durch Federn auf den Rahmen 402 gedrückt. Dadurch kann das optische Element 102 von den Aktuatoren 104 horizontal verschoben werden, wenn die Aktuatoren 104 bei Betätigung eine Reibkraft überwinden, durch die das optische Element 102 bei einer Nichtbetätigung der Aktuatoren 104 von den Federn fixiert wird.

Fig. 5 zeigt eine Draufsicht auf das Lichtsystem 400. Das optische Element 102 wird in diesem Ausführungsbeispiel von vier Aktuatoren 104 bewegt. Das optische Element 102 und der Rahmen 402 weisen eine quadratische Form auf. Die Aktuatoren 104 sind dazu ausgebildet, um das optische Elemente 102 zumindest in einer Richtung einer Erstreckungsebene des optischen Elements 102 zu bewegen. Dazu sind die Aktuatoren 104 auf zwei gegenüberliegenden Seiten des optischen Elements 102 angeordnet. Um das optische Element 102 in einer weiteren Richtung der Erstreckungsebene zu bewegen, können weitere Aktuatoren 104, die hier nicht dargestellt sind, an zwei weiteren gegenüberliegenden Seiten des optischen Elements 102 angeordnet sein. Auf einem Bereich des Rahmens 402, der nicht vom optischen Element 102 überdeckt ist, sind elektrische Kontaktstellen 500 angeordnet. Die elektrischen Kontaktstellen 500 können verwendet werden, um die Aktuatoren 104 und/oder die lichtemittierende Diode 106 mit elektrischer Energie zu versorgen. Die elektrischen Kontaktstellen 500 können als Bondpads ausgeführt sein. Von den elektrischen Kontaktstellen 500 können elektrische Leitungen durch den Rahmen 402 hindurch zu den Aktuatoren 104, sowie zur lichtemittierenden Diode 106 geführt sein.

Die Figuren 4 und 5 zeigen eine LED 106 für Beleuchtungszwecke mit MEMS aktuierter Optik 102. Diese Kombination kann als MEMS LED bezeichnet werden.

Durch eine Kombination einer LED 106 als Lichtquelle, einer direkt darüber befindlichen Optik 102 und einer Aktorik 104, die ganz oder teilweise in Silizium-Mikromechanik hergestellt ist, kann eine sehr kompakte Lampe hergestellt werden, die in der Lichtverteilung steuerbar ist. Durch Parallelisierung mehrerer dieser Einzellampen z.B. durch einen Aufbau auf je einem einzelnen oder einem gemeinsamen Träger kann eine sehr leistungsfähige Lampe bzw. Beleuchtung realisiert werden.

Das hier vorgestellte, von außen steuerbare optische System 102 kann entweder auf einer Spiegeloptik 102 oder einem Linsensystem 102, bevorzugt eine Fresnel-Linse, beruhen. Bei Verwendung von Silizium bietet sich für eine Spiegeloptik 102 die Verwendung und Integration von metallisierten Siliziumoberflächen oder Oberflächen mit dielektrischen Spiegelschichten an. Die Größe der gesamten Einheit 400 liegt dabei in einem Bereich von unter 10 mm x 10 mm x 10 mm, damit ist das gesamte System 400 nicht größer als eine heute erhältliche LED 106 mit Gehäuse.

Die Linse 102 oder der Spiegel 102 wird in der relativen Lage zur Lichtquelle 106 in mindestens einer Raumrichtung bewegt. Dies erfolgt in Fokusrichtung, um eine breitere oder schmalere Lichtabstrahlung zu erzeugen, und/oder in einer Ebene senkrecht dazu, um die Richtung der Lichtabstrahlung verändern zu können.

Die Aktuierung kann insbesondere elektrostatisch oder elektrothermisch erfolgen, weitere Aktuatorprinzipien sind aber auch vorstellbar, z.B. elektromagnetisch oder piezoelektrisch. Dabei kann das optische System 102 entweder kontinuierlich dynamisch aktuiert werden und ist dafür vorteilhafterweise starr mit dem Aktuator 104 verbunden. Das erfordert allerdings eine kontinuierliche Spannungsversorgung bzw. Ansteuerung. Alternativ kann die Aktuierung energielos remanent erfolgen, hier wird das optische System 102 bevorzugt über ein reibungsbasiertes System in Position gehalten. Die eigentliche Aktuierung erfolgt dann z.B. über einen Trägheitsantrieb.

Der Aktuator 104 kann über einen Rahmen 402 direkt mit der LED 106 verbunden werden, z.B. per Waferbonding, dazu ist eine Veränderung der elektrischen Anbindung der LED 106 vorteilhaft, z.B. in Form eines Kontaktrahmens 402 mit Fingern 404 von außen nach innen, wie in Fig. 4 dargestellt, anstelle eines Mittenkontaktes mit Fingern von innen nach außen wie in Fig. 3 dargestellt. Der Aktuatorrahmen 402 kann so bei einer leitfähiger Ausführung bzw. Beschichtung direkt zur elektrischen Kontaktierung der LED 106 verwendet werden. Alternativ besteht auch die Möglichkeit, LED 106 und Aktuator 104 über ein Packaging, insbesondere über einen Träger oder einen Sockel miteinander zu verbinden.

Haftet das optische System 102 auf den Rahmen 402 oder wird dieses z.B. über eine in Figur 4 nicht gezeigte Feder angedrückt, ist eine Reibungslagerung des optischen Systems 102 mit einem großen Verfahrweg möglich, wenn der Aktuator 104 so ausgelegt ist, dass er in mehreren Raumrichtungen bewegt werden kann Durch eine erste Bewegung der Aktoren 104 senkrecht zur Ebene des optischen Elements 102 wird dieses aus einer per Reibung fixierten Grundposition auf dem Rahmen 402 angehoben. Dann ist ein leichtes Verschieben des optischen Elementes 102 in mindestens einer weiteren Raumrichtung parallel zur LED 106 möglich. Nach dieser Positionierung von 102 wird die Grundposition in der ersten Richtung wieder durch die Aktoren 104 eingenommen, worauf sich durch Reibung zwischen 102 und 402 wieder eine feste Position von 102 realisieren lässt. Die Aktoren 104 können danach ohne Kontakt zum optischen System 102 wieder in eine Grundposition gefahren werden und das optische Element 102 wieder erst anheben und dann verschieben. Durch mehrfache Wiederholung dieses Vorgangs kann mit einem kleinen Verfahrweg des Aktors 104 ein sehr viel größerer Verfahrweg des optischen Elements 102 realisiert werden.

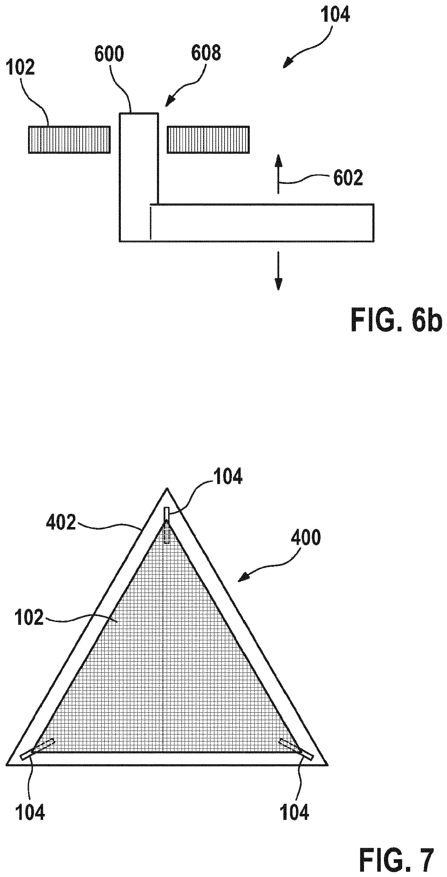

Die Figuren 6a und 6b zeigen eine Ansicht von unten und eine Schnittdarstellung eines Lagerhebels 600 und einer Lagerstelle in einem nur als Ausschnitt gezeigten, optischen Elements 102 gemäß einem Ausführungsbeispiel der vorliegenden Erfindung. Der mikromechanisch aktuierte Lagerhebel 600 ist dazu ausgebildet, das optische Element 102 in drei Raumrichtungen 602, 604, 606 zu bewegen. In einer y-Richtung 604, sowie in einer x-Richtung 606 ist das optische Element 102 durch direkten Kontakt zum Lagerhebel 600 geführt. In der z-Richtung 602 ist der Lagerhebel 600 durch ein Reibungslager 608 beweglich gelagert. Der Aktuator 104 ist an einem Ende als Lagerhebel 600 ausgebildet, um Bewegungen des Aktuators 104 auf das optische Element 102 zu übertragen. Das optische Element 102 kann beispielsweise eine Fresnel-Linse sein.

In Fig. 6a ist der Lagerhebel 600 von unten dargestellt, wie der Lagerhebel 600 in eine Aussparung im optischen Element 102 eingreift. Die Aussparung ist in diesem Ausführungsbeispiel quadratisch ausgeführt. Der Lagerhebel 600 ist entlang einer der Diagonalen der quadratischen Aussparung ausgerichtet. Der Lagerhebel 600 weist einen Lagerzapfen auf, der in der Aussparung Kontaktpunkte zu dem optischen Element 102 auf geraden Seiten der quadratischen Aussparung aufweist. Durch die Kontaktpunkte kann das optische Element 102 mit einer definierten Kraft auf dem Lagerzapfen des Lagerhebels 600 geklemmt sein.

In Fig. 6b ist der Lagerhebel 600 in einer Seitenansicht dargestellt. Der Lagerzapfen des Lagerhebels 600 ist senkrecht zu einer Haupterstreckungsebene des optischen Elements 102 ausgerichtet. Das optische Element 102 kann auf dem Lagerzapfen in z-Richtung 602 auf und ab bewegt werden. Wenn der Aktuator 104 eine schnelle Bewegung ausführt, dann kann eine Massenträgheit des optischen Elements 102 die Reibungskraft im Reibungslager 608 überwinden, und das optische Element 102 bewegt sich entlang des Lagerzapfens. Wenn der Aktuator 104 eine langsame Bewegung ausführt, dann ist die Reibungskraft im Reibungslager 608 größer als die Massenträgheit des optischen Elements 102, und das optische Element 102 wird von Lagerhebel 600 mitgenommen.

Die Figuren 6a und 6b zeigen ein Ausführungsbeispiel eines Einzelaktuators 104 gemäß dem hier vorgestellten Ansatz. Die Aufhängung ist in einer Dimension, hier in Fokusrichtung 602, remanent, in zwei Dimensionen senkrecht dazu 604, 606 kontinuierlich dynamisch aktuiert.

Gezeigt ist ein Ausführungsbeispiel für eine Einzelaufhängung für ein in drei Dimensionen bewegliches optisches System 102. Die Aufhängung ist in der Dimension in Fokusrichtung, hier der z-Richtung 602 remanent. Über eine Trägheitsansteuerung und Reibungslagerung 608 kann die Optik 102 in z- Richtung 602 verschoben werden, wie in Fig. 6b rechts unten als Querschnitt gezeigt. In den zwei Dimensionen senkrecht dazu 604, 606 kann die Optik kontinuierlich dynamisch aktuiert werden, wie in Fig. 6a als Aufsicht gezeigt.

Fig. 7 zeigt eine Darstellung eines Lichtsystems 400 gemäß einem Ausführungsbeispiel der vorliegenden Erfindung. Das Lichtsystem 400 weist eine dreieckige Form auf. Gezeigt sind ein Rahmen 402 und ein optisches Element 102, die jeweils dreieckig ausgeführt sind. Für die Bewegung der Optik 102 in mehreren Dimensionen ist es vorteilhaft, die Optik 102 an drei Stützstellen zu befestigen. Eine sehr gut dafür geeignete Form ist ein Dreieck, was sowohl bei LED als auch bei dem Aktuator 104 problemlos realisiert werden kann. In jeder der drei Ecken ist ein Aktuator 104 mit einem Lagerhebel angeordnet. Dadurch kann das optische Element 102 besonders einfach von nur drei Aktuatoren 104 bewegt werden.

Durch die dreieckige Form des Lichtsystems 400 können, viele gleichartige Lichtsysteme 400 eng nebeneinander angeordnet werden. Dadurch kann eine sehr hohe Packungsdichte erreicht werden. Leuchten, die mit dreieckigen oder beispielsweise sechseckigen Lichtsystemen 400 aufgebaut werden, können eine sehr homogene Lichtverteilung und hohe Lichtintensität aufweisen. Die einzelnen Lichtsysteme 400 können synchron angesteuert werden.

Mit anderen Worten zeigt Fig. 7 ein Ausführungsbeispiel der vorliegenden Erfindung für eine für drei Aufhängungspunkte optimierte LED mit Optik 102. Die dreieckige Form ermöglicht eine Verschiebung der Optik 102 in alle Richtungen mit kleinstmöglicher Anzahl von Aktuatoren 104. Während der Herstellung kann ein Sägen bei einer regelmäßigen Form ebenfalls einfach erfolgen, was zu drei Schnittrichtungen statt zwei beim rechteckigen Die führt.

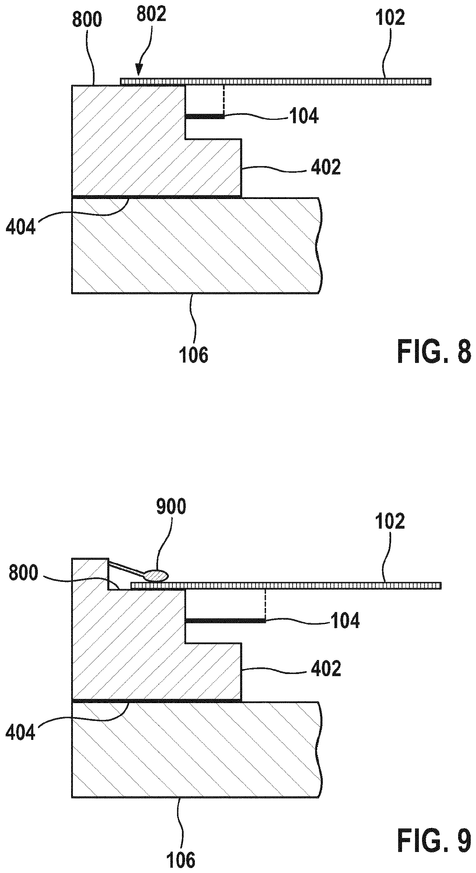

Fig. 8 zeigt ein Ausführungsbeispiel für eine Realisierung einer LED-Optik mit Reibungslagerung der Optik 102 an einem Ausschnitt aus einem Rahmen 402, wie er anhand von Fig. 4 beschrieben ist. Der Rahmen 402 weist eine Auflagefläche 800 auf, die auf einer der LED 106 gegenüberliegenden Seite des Rahmens 402 angeordnet ist. Auf der Auflagefläche 800 liegt ein Randbereich des optischen Elements 102 auf. Die Reibungslagerung kann auf der Auflagefläche 800 durch Adhäsion oder Kohäsion 802 der Oberflächen erfolgen oder durch geeignete Beschichtungen oder Materialien. Beispielsweise kann ein Fluid zwischen Optik 102 und Rahmen 402 angeordnet sein. Dabei kann die Adhäsion bzw. Kohäsion 802 zwischen Rahmen 402 und Optik 102, z.B. einer Fresnel-Linse, in einem Ruhezustand der Aktuatoren 104 die Optik 102 fixieren. Der abgebildete Aktuator 104 ist in einem Ruhezustand ohne feste Verbindung zur Optik 102 ausgeführt. Der mikromechanische Aktuator 104 ragt aus dem Rahmen 402 heraus. Der Rahmen 402 ist mittels einer Bondverbindung 404 mit dem Ausschnitt aus dem LED Die 106 verbunden.

Fig. 9 zeigt ein Ausführungsbeispiel für eine Realisierung einer LED-Optik mit Reibungslagerung der Optik 102 an einem Ausschnitt aus einem Rahmen 402, wie er anhand von Fig. 4 beschrieben ist. Auf einer Auflagefläche 800 liegt ein Randbereich des optischen Elements 102 auf. Der Rahmen 104 weist einen Absatz auf, auf dem das optische Element 102 aufliegt. Durch den Absatz wird ein seitlicher Überstand gebildet, der sich über das optische Element 102 hinaus erstreckt. An dem Überstand oder an einer anderen geeigneten Stelle des Rahmens 104 ist eine Feder 900 angeordnet. Ein freies Ende der Feder 900 liegt auf einer der Diode 106 gegenüberliegenden Oberfläche des optischen Elements 102 auf. Die Feder 900 erzeugt eine Kraft auf die Optik 102 wodurch diese auf eine Auflagefläche 800 des Rahmens 402 angedrückt wird. Es entsteht Reibung zwischen Optik 102 und Rahmen 402 und die Optik 102 wird fixiert. Mit den Aktuatoren 104 kann die Optik 102 vom Rahmen 402 angehoben und dann verschoben werden. Die Reibung zwischen Optik 102 und Feder 900 ist z.B. durch eine Verrundung der Feder 900 minimiert. Die Reibung zwischen Aktuator 104 und Optik 102 ist z.B. durch eine Spitze am Aktuator möglichst vergrößert. Der abgebildete Aktuator 104 ist in einem Ruhezustand ohne feste Verbindung zur Optik 102 ausgeführt. Der mikromechanische Aktuator 104 ragt aus dem Rahmen 402 heraus. Der Rahmen 402 ist mittels einer Bondverbindung 404 mit dem Ausschnitt aus dem LED Die 106 verbunden.

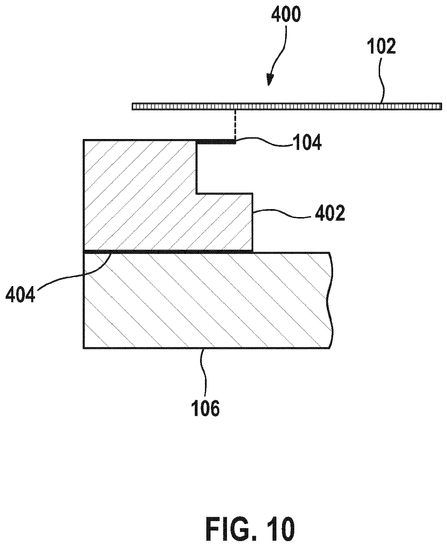

Fig. 10 zeigt einen Ausschnitt aus der in Fig. 4 gezeigten Schnittdarstellung durch das Lichtsystem 400 gemäß einem Ausführungsbeispiel der vorliegenden Erfindung. Der Rahmen 402 ist mittels einer Bondverbindung 404 mit dem LED Die 106 verbunden. Der mikromechanische Aktuator 104 ragt aus dem Rahmen 402 heraus. Die LED-Optik 102 ist fest auf den Aktoren 104 angebracht. Dies kann auch durch eine Reibungslagerung realisiert werden, wie sie in Fig. 6a beschrieben ist. In dem gezeigten Ausführungsbeispiel kann das optische Element 102 zusätzlich senkrecht zu der Diode 106 verschoben und gehalten werden. Dagegen ist eine Bewegung in einer Erstreckungsebene des optischen Elements auf einen Verfahrweg des Aktuators beschränkt.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können erfindungsgemäße Verfahrensschritte wiederholt sowie in einer anderen als in der beschriebenen Reihenfolge ausgeführt werden.

## Patentansprüche

1. Vorrichtung (100) zum Beeinflussen einer Abstrahlcharakteristik einer lichtemittierenden Diode (106), wobei die Vorrichtung (100) die folgenden Merkmale aufweist:
Ein optisches Element (102), das relativ zur lichtemittierenden Diode (106) zwischen einer ersten Position und zumindest einer weiteren Position beweglich anordenbar ist, und dazu ausgebildet ist, um eine erste Lichtverteilung des von der lichtemittierenden Diode (106) abgestrahlten Lichts zu bewirken, wenn das optische Element (102) in der ersten Position angeordnet ist, und um eine weitere Lichtverteilung des von der lichtemittierenden Diode (106) abgestrahlten Lichts zu bewirken, wenn das optische Element (102) in der zumindest einen weiteren Position angeordnet ist, und zumindest ein mikromechanischer Aktuator (104) zum Bewegen des optischen Elements (102) zwischen der ersten und der zumindest einen weiteren Position, um die Abstrahlcharakteristik zu beeinflussen,
**dadurch gekennzeichnet, dass** der Aktuator (104) ein Reibungslager (608) als Schnittstelle zwischen dem optischen Element (102) und dem Aktuator (104) aufweist.

2. Vorrichtung (100) nach Anspruch 1, **dadurch gekennzeichnet, dass** dass der mikromechanische Aktuator (104) Komponenten aufweist, deren Abmessungen im Mikrometerbereich liegen.

3. Vorrichtung (100) nach einem der vorhergehenden Ansprüche, **dadurch gekennzeichnet, dass** der mikromechanische Aktuator (104) aus Silizium, Siliziumcarbid, Galliumarsenid oder Galliumnitrid besteht

4. Vorrichtung (100) nach einem der vorhergehenden Ansprüche, bei der der Aktuator (104) dazu ausgebildet ist, um das optische Element (102) senkrecht und/oder parallel zu einer Haupterstreckungsebene der lichtemittierenden Diode (106) zu bewegen.

5. Vorrichtung (100) gemäß einem der vorangegangenen Ansprüche, bei der das optische Element (102) eine Linse oder ein optisches Gitter ist.

6. Vorrichtung (100) nach einem der Ansprüche 1-4, **dadurch gekennzeichnet, dass** das optische Element (102) eine Spiegeloptik ist.

7. Vorrichtung (100) gemäß einem der vorangegangenen Ansprüche, bei der der mikromechanische Aktuator (104) als elektrostatischer, thermischer, piezoelektrischer und/oder magnetischer Aktuator ausgeführt ist.

8. Vorrichtung (100) gemäß einem der vorangegangenen Ansprüche, bei der der Aktuator (104) einen Lagerhebel (600) zum Bewegen des optischen Elements (102) in zumindest einer Raumrichtung (602; 604, 606) aufweist.

9. Vorrichtung (100) gemäß einem der vorangegangenen Ansprüche, mit einem, die lichtemittierende Diode (106) umschließenden Rahmen (402) wobei der Aktuator (104) mit dem Rahmen (402) verbunden ist.

10. Vorrichtung (100) gemäß Anspruch 9, bei der der Rahmen (402) zumindest einen Versorgungsleiter (500) für den Aktuator (104), und/oder die lichtemittierende Diode (106) aufweist.

11. Vorrichtung (100) gemäß einem der Ansprüche 9 oder 10, bei der der Rahmen (402) ferner eine Auflagefläche (800) für das optische Element (102) aufweist, die dazu ausgebildet ist, das optische Element (102) verschiebbar zu lagern, wobei zwischen dem optischen Element (102) und der Auflagefläche (800) eine Haltekraft wirkt, die durch Adhäsion, Kohäsion (802) und/oder einer Feder (900) bewirkt wird.

12. Vorrichtung (100) gemäß einem der vorangegangenen Ansprüche, mit einem ersten Aktuator (104), der zum Bewegen des optischen Elements (102) mit einer ersten Ecke des optischen Elements (102) verbunden ist, einem zweiten Aktuator (104), der zum Bewegen des optischen Elements (102) mit einer zweiten Ecke des optischen Elements (102) verbunden ist, und einem dritten Aktuator (104), der zum Bewegen des optischen Elements (102) mit einer dritten Ecke des optischen Elements (102) verbunden ist.

13. Lichtsystem (400) mit veränderbarer Abstrahlcharakteristik, mit folgenden Merkmalen:
einer lichtemittierenden Diode (106); und
einer Vorrichtung (100) zum Beeinflussen einer Abstrahlcharakteristik einer lichtemittierenden Diode (106) gemäß einem der Ansprüche 1 bis 12, wobei ein erstes Ende des Aktuators (104) mit dem optischen Element (102), und ein zweites Ende des Aktuators (104) mit der lichtemittierenden Diode (106) verbunden ist.

14. Verfahren (200) zum Beeinflussen einer Abstrahlcharakteristik einer lichtemittierenden Diode (106) eines Lichtsystems (400) mit der lichtemittierenden Diode (106), einem optischen Element (102) und zumindest einem mikromechanischen Aktuator (104), wobei das optische Element (102) relativ zur lichtemittierenden Diode (106) zwischen einer ersten Position und zumindest einer weiteren Position beweglich angeordnet ist, und dazu ausgebildet ist, um eine erste Lichtverteilung des von der lichtemittierenden Diode (106) abgestrahlten Lichts zu bewirken, wenn das optische Element (102) in der ersten Position angeordnet ist, und um eine weitere Lichtverteilung des von der lichtemittierenden Diode (106) abgestrahlten Lichts zu bewirken, wenn das optische Element (102) in der zumindest einen weiteren Position angeordnet ist, und wobei der Aktuator (104) dazu ausgebildet ist, um das optische Element (102) zwischen der ersten und der zumindest einen weiteren Position zu bewegen, wobei das Verfahren (200) den folgenden Schritt aufweist:
Ansteuern (208) des zumindest einen Aktuators (104) mit einem Ansteuersignal zum Bewegen des optischen Elements (102), um die Abstrahlcharakteristik zu beeinflussen, **dadurch gekennzeichnet, dass** der Aktuator (104) ein Reibungslager (608) als Schnittstelle zwischen dem optischen Element (102) und dem Aktuator (104) aufweist.

## Claims

1. Device (100) for manipulating an emission characteristic of a light-emitting diode (106), the device (100) having the following features:
an optical element (102), which can be arranged movably relative to the light-emitting diode (106) between a first position and at least one further position, and is formed in order to induce a first light distribution of the light emitted by the light-emitting diode (106) when the optical element (102) is arranged in the first position, and in order to induce a further light distribution of the light emitted by the light-emitting diode (106) when the optical element (102) is arranged in the at least one further position, and at least one micromechanical actuator (104) for moving the optical element (102) between the first position and the at least one further position, in order to manipulate the emission characteristic,
**characterized in that** the actuator (104) has a friction bearing (608) as an interface between the optical element (102) and the actuator (104).

2. Device (100) according to Claim 1, **characterized in that** the micromechanical actuator (104) has components whose dimensions are in the micrometer range.

3. Device (100) according to either of the preceding claims, **characterized in that** the micromechanical actuator (104) consists of silicon, silicon carbide, gallium arsenide or gallium nitride.

4. Device (100) according to one of the preceding claims, wherein the actuator (104) is formed in order to move the optical element (102) perpendicularly and/or parallel to a main extent plane of the light-emitting diode (106).

5. Device (100) according to one of the preceding claims, wherein the optical element (102) is a lens or an optical grating.

6. Device (100) according to one of Claims 1-4, **characterized in that** the optical element (102) is an optical mirror unit.

7. Device (100) according to one of the preceding claims, wherein the micromechanical actuator (104) is configured as an electrostatic, thermal, piezoelectric and/or magnetic actuator.

8. Device (100) according to one of the preceding claims, wherein the actuator (104) has a bearing lever (600) for moving the optical element (102) in at least one spatial direction (602; 604, 606).

9. Device (100) according to one of the preceding claims, having a frame (402) enclosing the light-emitting diode (106), wherein the actuator (104) is connected to the frame (402).

10. Device (100) according to Claim 9, wherein the frame (402) has at least one supply conductor (500) for the actuator (104), and/or the light-emitting diode (106).

11. Device (100) according to Claim 9 or 10, wherein the frame (402) furthermore has a support surface (800) for the optical element (102), which is formed in order to bear the optical element (102) displaceably, a retaining force which is induced by adhesion, cohesion (802) and/or a spring (900) acting between the optical element (102) and the support surface (800).

12. Device (100) according to one of the preceding claims, having a first actuator (104) which is connected to a first corner of the optical element (102) in order to move the optical element (102), a second actuator (104) which is connected to a second corner of the optical element (102) in order to move the optical element (102), and a third actuator (104) which is connected to a third corner of the optical element (102) in order to move the optical element (102) .

13. Light system (400) having a variable emission characteristic, having the following features:
a light-emitting diode (106); and
a device (100) for manipulating an emission characteristic of a light-emitting diode (106) according to one of Claims 1 to 12, wherein a first end of the actuator (104) is connected to the optical element (102), and a second end of the actuator (104) is connected to the light-emitting diode (106).

14. Method (200) for manipulating an emission characteristic of a light-emitting diode (106) of a light system (400) comprising the light-emitting diode (106), an optical element (102) and at least one micromechanical actuator (104), wherein the optical element (102) is arranged movably relative to the light-emitting diode (106) between a first position and at least one further position, and is formed in order to induce a first light distribution of the light emitted by the light-emitting diode (106) when the optical element (102) is arranged in the first position, and in order to induce a further light distribution of the light emitted by the light-emitting diode (106) when the optical element (102) is arranged in the at least one further position, and wherein the actuator (104) is formed in order to move the optical element (102) between the first position and the at least one further position, the method (200) comprising the following step:
driving (208) the at least one actuator (104) with a drive signal for moving the optical element (102), in order to manipulate the emission characteristic, **characterized in that** the actuator (104) has a friction bearing (608) as an interface between the optical element (102) and the actuator (104).

## Revendications

1. Dispositif (100) permettant d'influer sur une caractéristique de rayonnement d'une diode électroluminescente (106), dans lequel le dispositif (100) comporte les éléments caractéristiques suivants :
un élément optique (102) pouvant être agencé de manière mobile par rapport à la diode électroluminescente (106) entre une première position et au moins une autre position, et conçu pour induire une première répartition lumineuse de la lumière émise par la diode électroluminescente (106), lorsque l'élément optique (102) est disposé à la première position, et pour induire une autre répartition lumineuse de la lumière émise par la diode électroluminescente (106) lorsque l'élément optique (102) est disposé à ladite au moins une autre position, et au moins un actionneur micromécanique (104) destiné à déplacer l'élément optique (102) entre la première position et ladite au moins une autre position, afin d'influer sur la caractéristique de rayonnement,
**caractérisé en ce que** l'actionneur (104) comporte un palier à frottement (608) en tant qu'interface entre l'élément optique (102) et l'actionneur (104).

2. Dispositif (100) selon la revendication 1, **caractérisé en ce que** l'actionneur micromécanique (104) comporte des composants dont les dimensions se situent dans le domaine micrométrique.

3. Dispositif (100) selon l'une des revendications précédentes, **caractérisé en ce que** l'actionneur micromécanique (104) est constitué de silicium, de carbure de silicium, d'arséniure de gallium ou de nitrure de gallium.

4. Dispositif (100) selon l'une quelconque des revendications précédentes, dans lequel l'actionneur (104) est conçu pour déplacer l'élément optique (102) perpendiculairement et/ou parallèlement à un plan d'extension principal de la diode électroluminescente (106) .

5. Dispositif (100) selon l'une des revendications précédentes, dans lequel l'élément optique (102) est une lentille ou un réseau de diffraction optique.

6. Dispositif (100) selon l'une quelconque des revendications 1-4, **caractérisé en ce que** l'élément optique (102) est une optique à miroir.

7. Dispositif (100) selon l'une des revendications précédentes, dans lequel l'actionneur micromécanique (104) est réalisé sous la forme d'un actionneur électrostatique, thermique, piézoélectrique et/ou magnétique.

8. Dispositif (100) selon l'une des revendications précédentes, dans lequel l'actionneur (104) comporte un levier de palier (600) destiné à déplacer l'élément optique (102) dans au moins une direction spatiale (602 ; 604, 606).

9. Dispositif (100) selon l'une des revendications précédentes, comportant un châssis (402) entourant la diode électroluminescente (106), dans lequel l'actionneur (104) est relié au châssis (402).

10. Dispositif (100) selon la revendication 9, dans lequel le châssis (402) comporte au moins un conducteur d'alimentation (500) destiné à l'actionneur (104) et/ou à la diode électroluminescente (106).

11. Dispositif (100) selon l'une des revendications 9 ou 10, dans lequel le châssis (402) comporte en outre une surface d'appui (800) destiné à l'élément optique (102), qui est conçue pour supporter de manière coulissante l'élément optique (102), dans lequel une force de maintien qui est provoquée par adhérence, par cohésion (802) et/ou par ressort (900), agit entre l'élément optique (102) et la surface d'appui (800) .

12. Dispositif (100) selon l'une des revendications précédentes, comportant un premier actionneur (104), qui est relié à un premier coin de l'élément optique (102) pour déplacer l'élément optique (102), un deuxième actionneur (104), qui est relié à un deuxième coin de l'élément optique (102) pour déplacer l'élément optique (102), et un troisième actionneur (104) qui est relié à un troisième coin de l'élément optique (102) pour déplacer l'élément optique (102).

13. Système d'éclairage (400) ayant des caractéristiques de rayonnement modifiables, présentant les éléments caractéristiques suivants :
une diode électroluminescente (106) ; et
un dispositif (100) permettant d'influer sur une caractéristique de rayonnement d'une diode électroluminescente (106) selon l'une des revendications 1 à 12, dans lequel une première extrémité de l'actionneur (104) est reliée à l'élément optique (102) et une deuxième extrémité de l'actionneur (104) est reliée à la diode électroluminescente (106).

14. Procédé (200) permettant d'influer sur une caractéristique de rayonnement d'une diode électroluminescente (106) d'un système d'éclairage (400) comportant la diode électroluminescente (106), un élément optique (102) et au moins un actionneur micromécanique (104), dans lequel l'élément optique (102) est agencé de manière mobile par rapport à la diode électroluminescente (106) entre une première position et au moins une autre position, et est conçu de manière à induire une première répartition lumineuse de la lumière émise par la diode électroluminescente (106), lorsque l'élément optique (102) est disposé à la première position, et de manière à induire une autre répartition lumineuse de la lumière émise par la diode électroluminescente (106), lorsque l'élément optique (102) est disposé à ladite au moins une autre position, et dans lequel l'actionneur (104) est conçu de manière à déplacer l'élément optique (102) entre la première position et ladite au moins une autre position, dans lequel le procédé (200) comprend les étapes consistant à :
commander (208) ledit au moins un actionneur (104) à l'aide d'un signal de commande destiné à déplacer l'élément optique (102) afin d'influer sur la caractéristique de rayonnement, **caractérisé en ce que** l'actionneur (104) comporte un palier à frottement (608) en tant qu'interface entre l'élément optique (102) et l'actionneur (104).
